# EUROPÄISCHE PATENTSCHRIFT

(11) **EP 1 825 530 B1**
(45) Veröffentlichungstag und Bekanntmachung des Hinweises auf die Patenterteilung: **22.10.2008**
(21) Anmeldenummer: 05787095.8
(22) Anmeldetag: 09.09.2005
(51) Int. Cl.: H01L 49/00, G01N 21/35

(54) **KOHÄRENTE TERAHERTZ-STRAHLUNGSQUELLE**
COHERENT TERAHERTZ RADIATION SOURCE
SOURCE DE RAYONNEMENTS TÉTRAHERTZ COHÉRENTS

(30) Priorität: 23.09.2004 DE 102004046123
(43) Veröffentlichungstag der Anmeldung: 29.08.2007
(73) Patentinhaber: Forschungszentrum Dresden - Rossendorf e.V., 01328 Dresden (DE)
(72) Erfinder: DEKORSY, Thomas, 78465 Litzelstetten (DE); HELM, Manfred, 01309 Dresden (DE); DREYHAUPT, André, 01097 Dresden (DE); WINNERL, Stephan, Dr., 01277 Dresden (DE)
(86) Internationale Anmeldenummer: PCT/DE2005/001578
(87) Internationale Veröffentlichungsnummer: WO 2006/047975

(56) Entgegenhaltungen:
- EP-A- 0 606 776
- US-A- 5 401 953
- US-A- 5 663 639
- US-A1- 2003 178 584
- PATENT ABSTRACTS OF JAPAN Bd. 2000, Nr. 05, 14. September 2000 (2000-09-14) -& JP 2000 049403 A (NEC CORP), 18. Februar 2000 (2000-02-18)
- AVETISYAN YU ET AL: "Now approach for THz-wave difference frequency generation in surface emitting geometry" CONFERENCE ON LASERS AND ELECTRO-OPTICS. (CLEO 2001). TECHNICAL DIGEST. POSTCONFERENCE EDITION. BALTIMORE, MD, MAY 6-11, 2001, TRENDS IN OPTICS AND PHOTONICS. (TOPS), US, WASHINGTON, WA : OSA, US, Bd. VOL. 56, 6. Mai 2001 (2001-05-06), Seiten 166-167, XP010559692 ISBN: 1-55752-662-1
- DREYHAUPT A ET AL: "Large-area high-power THz emitter based on interdigitated electrodes" INFRARED AND MILLIMETER WAVES, 2004 AND 12TH INTERNATIONAL CONFERENCE ON TERAHERTZ ELECTRONICS, 2004. CONFERENCE DIGEST OF THE 2004 JOINT 29TH INTERNATIONAL CONFERENCE ON KARLSRUHE, GERMANY SEPT. 27 - OCT. 1, 2004, PISCATAWAY, NJ, USA,IEEE, 27. September 2004 (2004-09-27), Seiten 83-84, XP010794975 ISBN: 0-7803-8490-3
- DREYHAUPT A ET AL: "High-intensity terahertz radiation from a microstructured large-area photoconductor" APPLIED PHYSICS LETTERS, AIP, AMERICAN INSTITUTE OF PHYSICS, MELVILLE, NY, US, Bd. 86, Nr. 12, 17. März 2005 (2005-03-17), Seiten 121114-121114, XP012064697 ISSN: 0003-6951

## Beschreibung

Die Erfindung betrifft eine Terahertz-Strahlungsquelle nach dem Oberbegriff des Anspruchs 1.

Kohärente Terahertzstrahlung ist für eine Vielzahl von Anwendungen wichtig. Der Frequenzbereich erstreckt sich von 10 GHz bis 50 Terahertz (THz). Mit Strahlung in diesem Frequenzbereich kann die komplexe Leitfähigkeit von Festkörpern, Halbleitern, Supraleitern und Dielektrika berührungslos und nicht-invasiv bestimmt werden. Auch für biologische Systeme, z.B. DNA, Sprengstoffe und medizinische Anwendungen, z.B. Kariesdiagnostik, zeichnen sich spezifische Vorteile für Untersuchungsmethoden mit THz-Strahlung ab [B. Ferguson und X.C. Zhang, Nature Materials, Vol. 1, pp. 26-33, 2002]. Die Erzeugung von kohärenterTHz-Strahlung kann in zwei Arten unterschieden werden:
1.Generation impulsiver THz-Strahlung: Mittels eines kurzen Laserpulses mit einer Pulsdauer unterhalb 1 Pikosekunde werden Ladungsträger in einem elektrisch vorgespanntem Halbleiter generiert. Deren Beschleunigung im elektrischen Feld führt entsprechend den Maxwell'schen Gleichungen zur Emission von THz-Strahlung. Da die Phase dieser Strahlung durch den anregenden Laserpuls wohl definiert ist, ist die Strahlung kohärent. Der so generierte THz-Strahlungspuls hat eine Bandbreite, die von der Pulsdauer des anregenden Laserpulses abhängt. Auf diese Art und Weise können THz-Strahlungsimpulse mit einem breiten Frequenzspektrum im Bereich von 10 GHz bis zu 30 THz generiert werden [US Patent 5.729.017].
2.Generation kontinuierlicher THz-Strahlung: Die zweite Methode besteht darin, die Ausgangsstrahlung von zwei kontinuierlich emittierenden Lasern in einem elektrisch vorgespannten Halbleiter zu überlagern. Diese Laser haben unterschiedliche Emissionsfrequenzen f₁ und f₂. Im elektrisch vorgespannten Halbleiter wird ein Photostrom erzeugt, der mit der Differenzfrequenz Δf=f₁-f₂ moduliert ist. Dieser Photostrom führt zur THz-Abstrahlung mit der Differenzfrequenz Δf. Durch Verstimmung der Laserfrequenzen ist auch die abgestrahlte THz-Strahlung in ihrer Frequenz einstellbar [E. R. Brown, K. A. McIntosh, K. B. Nichols und C. L. Dennis, Applied Physics Lettters, Vol. 66, pp.285-287, 1995].

Für beide Arten der THz-Strahlung, impulsive und kontinuierliche, wurden verschiedene Ausführungen von Strahlungsquellen und Strahlungsdetektoren beschrieben. Grundlage dieser Strahlungsquellen und Detektoren ist ein Halbleitersubstrat, das bei der Wellenlänge der verwendeten Laser absorbiert, d.h. dass durch die Absorption von Photonen Elektron-Loch Paare gebildet werden. Diese Ladungsträger werden in einem elektrischen Feld separiert und generieren so einen Photostrom. Die abgestrahlte THz-Strahlung ist proportional zur zeitlichen Änderung dieses Photostroms. Um eine möglichst intensive THz-Abstrahlung zu generieren, muss das elektrische Feld im Halbleiter möglichst groß und die Zahl der angeregten Ladungsträger möglichst hoch sein. Die physikalischen Grenzen für die Feldstärke sind gegeben durch die Durchbruchfeldstärke des Halbleiters (typische Werte liegen im Bereich von 100 kV/cm) und für die angeregte Ladungsträgerdichte durch die einfallende mittlere Laserleistung und die damit einhergehende thermische Belastung des Halbleiters.
Bei einem Detektor trifft die THz-Strahlung auf den Halbleiter, der gleichzeitig mit einem Laserpuls angeregt wird. In diesem Fall ist der Halbleiter nicht elektrisch vorgespannt und die einfallende THz-Welle erzeugt einen Photostrom, der proportional zur instantanen Feldstärke des THz-Strahlungsimpulses ist.
Die elektrische Vorspannung des Halbleiters wird im Fall einerTHz-Strahlungsquelle über zwei Metallkontakte realisiert, die auf der Oberfläche des Halbleiters aufgebracht werden. An diese Metallkontakte wird eine elektrische Spannung angelegt, so dass sich im Halbleiter ein Oberflächen-nahes elektrisches Feld ausbildet, in dem die photogenerierten Ladungsträger transportiert werden. Die Auskopplung der THz-Strahlung aus dem Halbleiter geschieht einerseits direkt durch den Photostrom im Halbleiter oder über eine metallische Antenne, die an die Metallkontakte gekoppelt ist. Eine solche Antenne schränkt oft den emittierenden Frequenzbereich durch ihre Frequenzcharakteristik ein. Die Nachteile aller bisherigen Ausführungen von solchen THz-Strahlungsquellen sind: Um eine hohe elektrische Feldstärke im Halbleiter zu erzeugen, müssen die Metallkontakte einen geringen Abstand haben. Das maximale elektrische Feld F berechnet sich nach F=U/d, wobei U die an die Metallkontakte angelegte Spannung und d der Elektrodenabstand ist. Die Durchbruchfeldstärke liegt für viele Halbleiter im Bereich von 100 kV/cm, was mit einem Elektrodenabstand von 1 µm und einer Spannung von 10 V erreicht wird. Damit wird gleichzeitig aber die nutzbare Fläche des Halbleiters zur optischen Anregung nachteilig auf einige µm² beschränkt. Auf eine solche kleine Fläche lässt sich nur eine beschränkte mittlere Laserleistung einkoppeln, da sich sonst der Halbleiter lokal erwärmt oder irreversibel geschädigt wird. Eine Erwärmung hat eine Reduktion der Ladungsträgerbeweglichkeit zur Folge und reduziert damit die zeitlichen Änderungen des Photostroms und führt zu verminderter Intensität der THz-Abstrahlung. Es wurde versucht, den vorstehend beschriebenen Nachteil zu umgehen, indem der Abstand der Metallkontakte groß gewählt wird, d.h. im Bereich von einigen 100 µm bis zu cm. Somit kann der Halbleiter mit dem anregenden Laser großflächig mit einer höheren mittleren Leistung bestrahlt werden. Um mit einem solchen Elektrodenabstand in den Bereich hoher elektrischer Felder von 100 kV/cm zu kommen, müsste bei 1 mm Elektrodenabstand bereits eine Spannung von 10000 V angelegt werden. Solche Spannung sind für einen technische Nutzung jedoch nachteilig. Um solch hohen Spannungen nicht kontinuierlich anlegen zu müssen, werden auch gepulste Spannungsquellen genutzt. Dieser generieren in der Regel starke elektrische Störungen in den für die THz Detektion eingesetzten Detektoren und Messgeräten [Patent DE 100 02 728 A1; G. Zhao, R. N. Schouten, N. van der Valk, W. Th. Wenckebach und P. C. M. Planken, Review of Scientific Instruments, Vol. 73, pp. 1715.1719, 2002].

In der Patentschrift US 5 663 639 wird eine kohärente Terahertz-Strahlungsquelle mit periodisch strukturierten Elektroden beschrieben.

Der Erfindung wie durch Anspruch 1 definiert liegt die Aufgabe zugrunde, eine kohärente THz-Strahlungsquelle im Frequenzbereich zwischen 10 GHz und 50 THz zu realisieren. Dabei soll die technische Lösung für Flächen von mehr als 100 µm² geeignet sein, das elektrische Feld im Halbleitersubstrat der THz-Strahlungsquelle Werte oberhalb 10 kV/cm aufweisen können und mit Spannungen kleiner als 100 V für den Betrieb der Strahlungsquelle auskommen.

Diese Aufgabe wird erfindungsgemäß durch eine kohärente THz-Strahlungsquelle mit den Merkmalen des Anspruchs 1 gelöst. Den Erfindungsanspruch vorteilhaft weiterbildende Merkmale sind Gegenstand der Unteransprüche sowie der Beschreibung unter Bezugnahme auf die Ausführungsbeispiele mit den dazugehörigen Abbildungen zu entnehmen.

Die Erfindung wird nachfolgend an einem Ausführungsbeispiel näher erläutert. In der zugehörigen Zeichnung zeigen
Abbildung 1 die schematische Darstellung einer Ausführungsform einer kohärenten THz-Strahlungsquelle,
Abbildung 2 die schematische Darstellung eines Querschnitts durch eine Ausführungsform einer kohärenten THz-Strahlungsquelle und
Abbildung 3 die emittierte Frequenzspektren einer Ausführung einer kohärenten THz-Strahlungsquelle für verschiedene angelegte Spannungen.

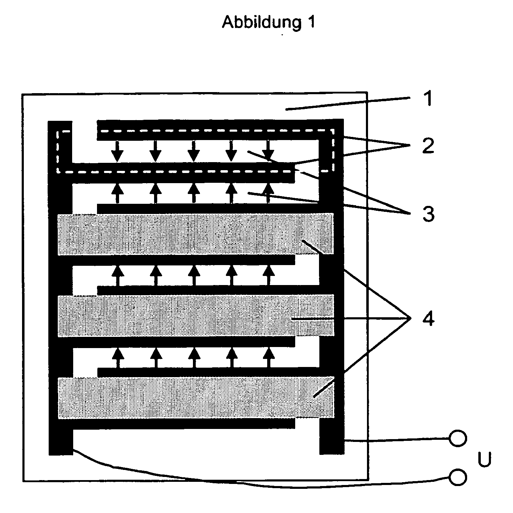

Abbildung 1 enthält eine schematische Darstellung der Ausführungsform einer kohärenten THz-Strahlungsquelle. Die Grundlage der kohärenten THz-Strahlungsquelle bildet ein Halbleitersubstrat 1. Dieses Halbleitersubstrat kann aus bekannten Halbleitern bestehen, vorteilhaft sind Verbindungshalbleiter der III-ten und V-ten Periode des Periodensystems mit hoher Beweglichkeit und/oder hoher Durchbruchfeldstärke, wie zum Beispiel GaAs, InP, GaSb, InSb, InGaAs, GaN, InGaN, GaNAs oder GalnNAs. Diese Halbleitersubstrate können in besonderer Weise modifiziert werden, etwa über lonenimplantation und/oder besondere Wachstumsbedingungen, um die Durchbruchfeldstärke zu erhöhen, insbesondere sogenanntes Tieftemperaturgewachsenes GaAs.
Auf das Halbleitersubstrat werden zwei Metallkontakte 2 aufgebracht, die in einer periodischen, ineinandergreifenden Fingerstruktur ausgeführt werden. Die Anzahl der Perioden der Struktur soll größer 1 sein und ist nach oben offen. In Abbildung 1 sind beispielhaft 4 Perioden dargestellt. Die Periode der Kontaktfinger kann zwischen 100 nm und 10 µm liegen. Je kleiner die Periode, desto größer ist gemäß F=U/d das im Halbleitersubstrat erzielbare elektrische Feld bei einer gegebenen Spannung U. Die Breite der Kontaktfinger kann zwischen 100 nm und einigen µm liegen. Wird an die zwei Metallkontakte eine Spannung angelegt, so bildet sich ein elektrisches Feld 3 im Halbleitersubstrat aus, das zwischen den Metallkontakten jeweils sein Vorzeichen ändert. Vorteilhaft kann eine Ausführung sein, bei der die Ausführung der periodischen Metallkontakte asymmetrisch ist, d.h. dass die Elektrodenabstände für eine sich einstellende Feldrichtung größer sind als für die entgegengesetzte Feldrichtung.
Der bisher beschriebenen Anordnung wird nun eine weitere Schicht überlagert, die zum Zweck hat, dass die optische Anregung des Halbleitersubstrates nur in den Bereichen zwischen den Metallkontakten erfolgt, die die gleiche Feldrichtung aufweisen. Zu diesem Zweck wird eine obere periodische Struktur 4 aus einem Material aufgebracht, das entweder das einfallende Licht in dem ungewünschten Gebiet absorbiert oder reflektiert. Durch diese Anordnung werden optisch generierte Ladungsträger unidirektional entlang der nicht-verdeckten Richtung des elektrischen Feldes beschleunigt. Dies führt zu einer Emission von THz-Strahlung, die sich im Fernfeld der THz-Strahlungsquelle konstruktiv und kohärent überlagert. Ohne die obere periodische Struktur 4 werden die Ladungsträger alternierend in jeder Periode in jeweils entgegengesetzte Feldrichtungen beschleunigt. Dies führt zu destruktiven Interferenz der abgestrahlten THz Leistung im Fernfeld der THz-Strahlungsquelle und ist für Anwendungen folglich völlig ungeeignet. Es sei noch angemerkt, dass in Abbildung 1 im oberen Teil eine obere periodische Struktur nur in ihren Umrissen gestrichelt gezeichnet wurde, um den alternierenden elektrischen Feldverlauf im Halbleitersubstrat 1 zwischen den Metallkontakten darzustellen.

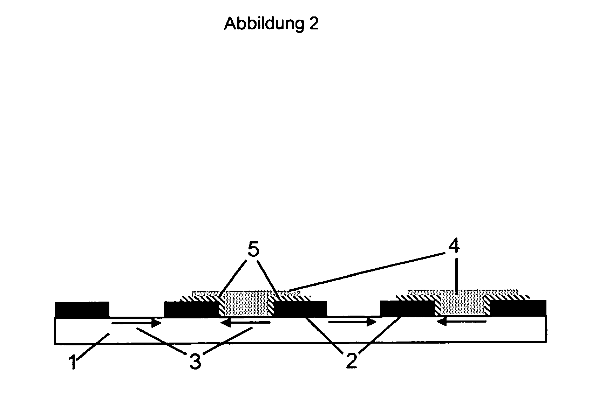

Die obere periodische Struktur 4 kann in verschiedenen Ausführungen erfolgen. Eine Ausführungsvariante ist in Abbildung 2 im Querschnitt senkrecht zu den Metallkontakten dargestellt. Auf die beiden Metallkontakte 2 wird eine elektrisch isolierende Schicht 5 aufgebracht. Dies kann zum Beispiel ein nicht-leitender Kunststoff, Siliziumdioxid, Siliziumnitrid oder andere in der Halbleitertechnik gebräuchliche Isolatoren sein. Auf diesen Isolator wird eine periodische strukturierte Metallschicht aufgebracht, die die optische Anregung in jeder zweiten Periode der periodischen Metallkontakte 2 verhindert. Eine weitere Ausführungsform wäre, dass statt der Isolationsschicht und der periodisch strukturierten Metallschicht eine dielektrische Multischicht auf die beiden Metallkontakte aufgebracht wird. Diese Multischicht bildet einen Braggspiegel für die mittlere Wellenlänge des einfallenden Laserlichts. Diese Multischicht wird genau wie die obere periodische Metallschicht so strukturiert, dass sie in den Bereichen entfernt wird, in denen das Laserlicht das Halbleitersubstrat anregen soll.

Eine weitere Ausführungsform der kohärenten THz-Strahlungsquelle besteht aus einer Modifikation des Halbleitersubstrats zwischen den Metallkontakten 2 in den Bereichen, in denen die optische Anregung durch die obere periodische Struktur 4 in der oben beschriebenen Ausführungsform unterdrückt wird. Diese Modifikation des Halbleitersubstrats 1 kann durch Ionenimplantation bewirkt werden und hat zur Folge, dass das Halbleitersubstrat 1 in diesem Bereich nicht absorbiert oder optisch angeregte Ladungsträger in diesem Bereich ein wesentlich geringere Mobilität als in den nichtimplantierten Bereichen besitzen. Dadurch kann die obere periodische Struktur 4 entfallen.

Eine weitere Ausführungsform der kohärenten Strahlungsquelle besteht darin, dass die periodisch angeordneten Metallkontakte 2 durch Implantation des Halbleitersubstrats 1 in dasselbe direkt hinein geschrieben werden. So kann zum Beispiel einer der Metallkontakte durch ein hohe p-Dotierung und der andere durch eine hohe n-Dotierung im Halbleitersubstrat ersetzt werden. Zwischen diesen beiden Elektroden bildet sich dann ein periodischer p-n oder p-i-n Übergang aus, der über eine elektrische Spannung in Sperrrichtung vorgespannt wird. In diesem periodischen p-n Übergang werden Bereich mit gleicher elektrischer Feldrichtung durch die obere periodische Struktur abgedeckt.

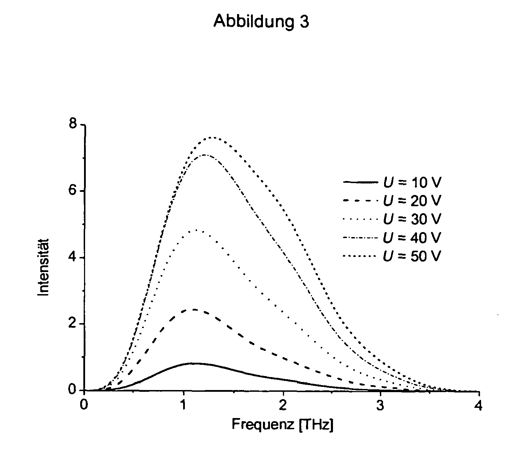

Abbildung 3 zeigt Frequenzspektren der THz-Strahlung, die mit einer hier beschriebenen kohärenten THz-Strahlungsquelle bei verschiedenen angelegten Spannungen generiert wurden. Die verwendeten Spezifikationen der untersuchten Ausführung der Strahlquelle sind: Halbleitersubstrat GaAs, Periode der Metallkontakte 10 µm, Abstand von zwei Metallkontaktfingern 5 µm, Breite der Metallkontaktfinger 5 µm, Metallkontaktmaterial Gold, Dicke der Isolierschicht 500 nm, Material der Isolierschicht Siliziumoxid, Periode der oberen periodischen Struktur 20 µm, Material der oberen periodischen Struktur Gold, Abmessungen des gesamten kohärenten THz-Strahlungsquelle 2 mm x 2 mm.
Die Spektren erstrecken sich über einen Frequenzbereich von 10 GHz bis 5 THz. Die obere Grenze der detektierten THz-Strahlung ist durch das Detektionsprinzip gegeben, nicht jedoch durch die Emissionscharakteristik der kohärenten THz-Strahlungsquelle. Es ist deutlich zu sehen, dass mit zunehmender an die Metallkontakte angelegter Spannung die Intensität der emittierten THz-Strahlung zunimmt.

Des weiteren kann es vorteilhaft sein, die Intensität der emittierten THz-Strahlung dadurch zu erhöhen, dass die kohärente THz-Strahlungsquelle sich in einem statischen magnetischen Feld befindet.

Weiterhin vorteilhaft kann eine Ausführung sein, bei der die THz-Strahlungsquelle zum Beispiel durch ein Peltier-Element gekühlt wird, um die durch die Laserstrahlung eingebrachte Wärme abzuführen.

Eine weitere vorteilhafte Ausführung kann daraus bestehen, dass das Halbleitersubstrat 1 aus einem dünnen Halbleiterfilm mit einer Dicke größer 100 nm besteht, der auf einem anderen Halbleitersubstrat oder dielektrischem Substrat aufgebracht wurde.

### Bezugszeichenliste

- **1**: Halbleitersubstrat
- **2**: Metallkontakte
- **3**: elektrisches Feld
- **4**: obere periodische Struktur
- **5**: elektrische Isolationsschicht

## Patentansprüche

1. Kohärente Terahertz-Strahlungsquelle zur Erzeugung von kohärenter elektromagnetischer Strahlung im Frequenzbereich von 10 GHz bis 50 THz, welche aus einem Halbleitersubstrat **(1)** besteht, das bei der Wellenlänge einer einfallenden impulsiven Laserstrahlung oder bei den Wellenlängen von zwei kontinuierlich emittierenden Lasern mit einstellbarer Frequenzdifferenz absorbiert und auf welches zwei elektrische Metallkontakte **(2)** aufgebracht sind, über die im Halbleitersubstrat ein elektrisches Feld **(3)** zwischen den Metallkontakten erzeugt wird, wobei die beiden elektrischen Metallkontakte (1) periodisch strukturiert sind, so dass das elektrische Feld im Halbleitersubstrat (1) seine Richtung periodisch ändert **dadurch gekennzeichnet, dass** sich auf den beiden Metallkontakten eine obere periodische Struktur **(4)** befindet, welche die optische Anregung von Ladungsträgern im Halbleiter nur in den Gebieten erlaubt, in denen das elektrische Feld die gleiche Richtung aufweist.

2. Kohärente Terahertz-Strahlungsquelle nach Anspruch 1 **dadurch gekennzeichnet dass** sich die auf den Metallkontakten befindliche obere periodische Struktur **(4)** aus einer elektrischen Isolationsschicht **(5)** und einer darauf aufgebrachten periodischen Schicht zusammensetzt, wobei besagte periodische Schicht das einfallende Laserlicht reflektiert oder absorbiert, so dass das darunter liegende Halbleitersubstrat nicht optisch angeregt wird.

3. Kohärente Terahertz-Strahlungsquelle nach Anspruch 1 und 2 **dadurch gekennzeichnet, dass** die Periode der elektrischen Metallkontakte **(2)** im Bereich kleiner als 100 µm, insbesondere kleiner als 10 µm, insbesondere kleiner als 1 µm liegt.

4. Kohärente Terahertz-Strahlungsquelle nach Anspruch 1 und 2, **dadurch gekennzeichnet, dass** die periodische Struktur der Metallkontakte asymmetrisch ausgeführt ist, so dass der Bereich des Halbleitersubstrats, der von der einfallenden Laserstrahlung angeregt wird größer ist als der Bereich, der von der oberen periodischen Struktur bedeckt wird.

5. Kohärente Terahertz-Strahlungsquelle nach Anspruch 1,2 und 4, **dadurch gekennzeichnet, dass** die periodische Struktur der Metallkontakte asymmetrisch ausgeführt ist, so dass der Bereich des Halbleitersubstrats, der von der einfallenden Laserstrahlung angeregt wird größer ist als der Bereich ist, in dem das elektrische Feld gegenüber dem erstgenannten Bereich eine umgekehrte Richtung aufweist, so dass keine destruktive Interferenz derTHz-Strahlung im Fernfeld auftritt und die obere periodische Struktur (4) entfallen kann.

6. Kohärente Terahertz-Strahlungsquelle nach Anspruch 1, **dadurch gekennzeichnet, dass** die von den elektrischen Metallkontakten bedeckte Fläche des Halbleitersubstrates größer als 10 µm² ist, insbesondere größer als 100 µm² insbesondere größer als 1 mm, insbesondere größer als 1 cm² insbesondere größer als 10 cm².

7. Kohärente Terahertz-Strahlungsquelle nach Anspruch 1, **dadurch gekennzeichnet, dass** die obere periodische Struktur aus mehreren Schichten dielektrischer Materialien besteht, die einen Braggspiegel mit einer Reflektivität größer als 90% für die mittlere Wellenlänge des einfallenden Laserlichts darstellt.

8. Kohärente Terahertz-Strahlungsquelle nach Anspruch 1, 4 und 5 **dadurch gekennzeichnet, dass** die periodischen Metallkontakte (2) mittels lonenimplantation direkt als gut leitende Bereiche in das Halbleitersubstrat (1) geschrieben sind.

9. Kohärente Terahertz-Strahlungsquelle nach Anspruch 1, 4, 5 und 8, **dadurch gekennzeichnet, dass** die periodischen Metallkontakte (2) mittels lonenimplantation direkt als gut leitende Bereiche in das Halbleitersubstrat (1) geschrieben sind sowie einer der Metallkontakte p-leitend und der zweite Metallkontakt n-leitend ist.

## Claims

1. Coherent terahertz radiation source for generating coherent electromagnetic radiation in the frequency range from 10 GHz to 50 THz comprising a semiconductor substrate (1), which absorbs at the wavelength of incident impulsive laser radiation or at the wavelengths of two continuously emitting lasers with an adjustable frequency difference, and onto which two electrical metal contacts (2) are applied, by means of which an electric field (3) is generated in the semiconductor substrate between the metal contacts, the two electrical metal contacts (1) being structured with a regular pattern such that the electric field in the semiconductor substrate (1) changes its direction at regular intervals, **characterized in that** an upper structure (4) with a regular pattern is located on the two metal contacts and only permits optical excitation of charge carriers in the semiconductor in regions in which the electric field has the same direction.

2. Coherent terahertz radiation source according to Claim 1, **characterized in that** the upper structure (4) with a regular pattern located on the metal contacts comprises an electric insulation layer (5) and a layer with a regular pattern applied thereto, the indicated layer with a regular pattern reflecting or absorbing the incident laser light so that the semiconductor substrate lying below is not excited optically.

3. Coherent terahertz radiation source according to Claims 1 and 2, **characterized in that** the interval of the electrical metal contacts (2) is in the region of less than 100 µm, in particular less than 10 µm, in particular less than 1 µm.

4. Coherent terahertz radiation source according to Claims 1 and 2, **characterized in that** the structure with a regular pattern of the metal contacts is designed asymmetrically so that the region of the semiconductor substrate excited by the incident laser radiation is greater than the region covered by the upper structure with a regular pattern.

5. Coherent terahertz radiation structure according to Claims 1, 2 and 4, **characterized in that** the structure with a regular pattern of the metal contacts is designed asymmetrically so that the region of the semiconductor substrate excited by the incident laser radiation is greater than the region in which the electric field has an opposing direction with respect to the first-mentioned region, so that no destructive interference of the THz radiation occurs in the far-field and the upper structure (4) with a regular pattern can be dispensed with.

6. Coherent terahertz radiation source according to Claim 1, **characterized in that** the area of the semiconductor substrate covered by the electrical metal contacts is greater than 10 µm², in particular greater than 100 um², in particular greater than 1 mm², in particular greater than 1 cm², in particular greater than 10 cm².

7. Coherent terahertz radiation source according to Claim 1, **characterized in that** the upper structure with a regular pattern comprises a plurality of layers of dielectric materials and constitutes a Bragg mirror with a reflectivity of greater than 90% for the mid-wavelength of the incident laser light.

8. Coherent terahertz radiation source according to Claims 1, 4 and 5, **characterized in that** the metal contacts (2) with a regular pattern are written directly into the semiconductor substrate (1) as well-conducting regions by means of ion implantation.

9. Coherent terahertz radiation source according to Claims 1, 4, 5 and 8, **characterized in that** the metal contacts (2) with a regular pattern are written directly into the semiconductor substrate (1) as well-conducting regions by means of ion implantation and one of the metal contacts is a p-type and the second metal contact is an n-type.

## Revendications

1. Source de rayonnement cohérente dans la gamme des Térahertz pour générer un rayonnement électromagnétique cohérent dans la gamme des fréquences de 10 GHz à 50 THz, laquelle se compose d'un substrat en semiconducteur (1) qui est absorbant à la longueur d'onde d'un rayonnement laser pulsé incident ou aux longueurs d'onde de deux lasers émettant continuellement avec une différence de fréquence réglable et sur lequel sont montés deux contacts métalliques électriques (2) par le biais desquels un champ électrique (3) est produit dans le substrat en semiconducteur entre les contacts métalliques, les deux contacts métalliques électriques (1) étant structurés de manière périodique de sorte que le champ électrique dans le substrat en semiconducteur (1) change périodiquement sa direction, **caractérisée en ce que** sur les deux contacts métalliques se trouve une structure périodique supérieure (4) qui ne permet l'excitation optique des porteurs de charge dans le semiconducteur que dans les régions où le champ électrique présente la même direction.

2. Source de rayonnement cohérente dans la gamme des Térahertz selon la revendication 1, **caractérisée en ce que** la structure périodique supérieure (4) qui se trouve sur les contacts métalliques est composée d'une couche électriquement isolante (5) et d'une couche périodique appliquée sur celle-ci, ladite couche périodique réfléchissant ou absorbant la lumière laser incidente de sorte que le substrat en semiconducteur qui se trouve au-dessous n'est pas excité optiquement.

3. Source de rayonnement cohérente dans la gamme des Térahertz selon les revendications 1 et 2, **caractérisée en ce que** la période des contacts métalliques électriques (2) se trouve dans la plage au-dessous de 100 µm, notamment au-dessous de 10 µm et plus particulièrement au-dessous de 1 µm.

4. Source de rayonnement cohérente dans la gamme des Térahertz selon les revendications 1 et 2, **caractérisée en ce que** la structure périodique des contacts métalliques est réalisée de manière asymétrique de sorte que la zone du substrat en semiconducteur qui est excitée par le rayonnement laser incident est plus grande que la zone qui est recouverte par la structure périodique supérieure.

5. Source de rayonnement cohérente dans la gamme des Térahertz selon les revendications 1, 2 et 4, **caractérisée en ce que** la structure périodique des contacts métalliques est réalisée de manière asymétrique de sorte que la zone du substrat en semiconducteur qui est excitée par le rayonnement laser incident est plus grande que la zone dans laquelle le champ électrique présente une direction inverse par rapport à la première zone mentionnée, de sorte qu'il ne se produise aucune interférence destructrice du rayonnement THz dans le champ lointain et que la structure périodique supérieure (4) puisse être supprimée.

6. Source de rayonnement cohérente dans la gamme des Térahertz selon la revendication 1, **caractérisée en ce que** la surface recouverte par les contacts métalliques électriques du substrat en semiconducteur est plus grande que 10 µm², notamment plus grande que 100 µm² , notamment plus grande que 1 mm², notamment plus grande que 1 cm², notamment plus grande que 10 cm².

7. Source de rayonnement cohérente dans la gamme des Térahertz selon la revendication 1, **caractérisée en ce que** la structure périodique supérieure se compose de plusieurs couches de matériaux diélectriques et représente un miroir de Bragg ayant une réflectivité supérieure à 90 % pour la longueur d'onde moyenne de la lumière laser incidente.

8. Source de rayonnement cohérente dans la gamme des Térahertz selon les revendications 1, 4 et 5, **caractérisée en ce que** les contacts métalliques périodiques (2) sont gravés directement en tant que zones bonnes conductrices dans le substrat en semiconducteur (1) par implantation d'ions.

9. Source de rayonnement cohérente dans la gamme des Térahertz selon les revendications 1, 4, 5 et 8, **caractérisée en ce que** les contacts métalliques périodiques (2) sont gravés directement en tant que zones bonnes conductrices dans le substrat en semiconducteur (1) par implantation d'ions et l'un des contacts métalliques est à conduction p et le deuxième contact métallique est à conduction n.
